(19) **Europäisches Patentamt**

**European Patent Office**

**Office européen des brevets**

(11) Veröffentlichungsnummer: **0 044 906**
**B1**

(12) **EUROPÄISCHE PATENTSCHRIFT**

(45) Veröffentlichungstag der Patentschrift:
**29.10.86**

(21) Anmeldenummer: **81102478.5**

(22) Anmeldetag: **02.04.81**

(51) Int. Cl.⁴: **G 02 F 1/133**, B 23 K 1/20,
**B 32 B 15/00**

(54) **Lötfähiges Schichtensystem.**

(30) Priorität: **24.07.80 DE 3028044**

(43) Veröffentlichungstag der Anmeldung:
**03.02.82 Patentblatt 82/5**

(45) Bekanntmachung des Hinweises auf die Patenterteilung:
**29.10.86 Patentblatt 86/44**

(84) Benannte Vertragsstaaten:
**FR GB IT NL SE**

(56) Entgegenhaltungen:
**CH - A - 557 071**
**DE - A - 1 965 182**
**DE - A - 2 321 099**
**FR - A - 2 182 209**
**GB - A - 2 016 985**

**IBM TECHNICAL DISCLOSURE BULLETIN, Band 18, Nr. 6, November 1975, Seite 1759, New York, US, W.C. WARD: "Substrate solderability enchancement"**
**IBM TECHNICAL DISCLOSURE BULLETIN, Band 20, Nr. 6, November 1977, Seite 2314, New York, US, G. DIGIACOMO: "Passivation of lead/indium solder pads"**

(73) Patentinhaber: **VDO Adolf Schindling AG, Gräfstrasse 103, D-6000 Frankfurt/Main (DE)**

(72) Erfinder: **Nickol, Friedrich Wilhelm, Am Honigbaum 35, D-6239 Eppstein 4 (DE)**
Erfinder: **Baeger, Holm, Dr., Salzbornstrasse 1, D-6231 Schwalbach (DE)**

(74) Vertreter: **Könekamp, Herbert, Dipl.-Ing., Sodener Strasse 9, D-6231 Schwalbach (DE)**

**Beschreibung**

Die Erfindung betrifft ein Träger-Schichten-System mit einer auf dem Träger befindlichen nicht lötfähigen Metalloxyd-Leiterschicht und einem eine Löt-Anschlussstelle für diese Leitschicht bildenden Schichtensystem bestehend aus einer Lötschicht und einer diese überdeckenden und gegen Oxydation schützenden Korrosionsschutzschicht.

Bei einem derartigen Schichtensystem (DE-A-2321099) ist es bekannt, auf einen Träger eine Haftvermittlerschicht aufzubringen, die die Lötschicht trägt. Die Haftvermittlerschicht dient zur besseren Haftung der Lötschicht auf dem Träger. Damit die Lötschicht, die vorzugsweise aus Kupfer oder Eisen besteht, nicht korrodiert, wird sie durch eine Korrosionsschutzschicht aus Gold überdeckt. Diese Goldschicht verhindert, dass Sauerstoff zur Lötschicht gelangen kann. Da aber beim direkten Auftragen der Goldschicht auf die Lötschicht eine zumindest teilweise Vermischung dieser beiden Schichten erfolgen würde, wird zwischen Gold und Lötschicht noch eine Diffusionssperrschicht, z.B. aus Palladium, Nickel oder Platin aufgebracht.

Ein solches Schichtensystem ist zum einen durch das erforderliche aufwendige Herstellungsverfahren, das für die vier Schichten vier aufeinanderfolgende Prozessschritte erfordert und durch das als Korrosionsschutzschicht verwendete Gold sehr teuer.

Aus der DE-A-1 965 182 ist ein lötbares Schichtensystem bekannt, das zur Vermeidung von Korrosion aufgrund normaler Umweltbedingungen mit einer dünnen Korrosionsschutzschicht, z.B. aus Gallium, versehen ist, die aufgrund ihrer geringen Dicke bei einem späteren Lötvorgang auf dem Schichtensystem verbleibt.

Es ist daher Aufgabe der Erfindung, ein Schichtensystem nach dem Oberbegriff zu schaffen, das einfach und kostengünstig herstellbar ist.

Diese Aufgabe wird erfindungsgemäss dadurch gelöst, dass die Korrosionsschutzschicht aus einem bezüglich Oxydation korrosiven Metall oder Metalloxyd besteht, dass die Leiterschicht nicht vollständig durchoxydiert ist und dass die Korrosionsschutzschicht ein solches Material und eine solche Dicke aufweist, dass sie einerseits die Lötschicht auch während eines zum Zwecke der Durchoxydierung der Leiterschicht vorgesehenen Hochtemperaturprozesses vor Oxydation schützt, andererseits aber beim Lötvorgang stören würde und deshalb vor Beginn des Lötvorgangs entfernt werden muss.

Dabei kann die dünne Korrosionsschutzschicht vorteilhafterweise aus Silicium, Zinn oder Indium bestehen, was gegenüber dem seither verwandten Gold den Vorteil der wesentlich geringeren Kosten hat. Es ist aber auch möglich, dass die Korrosionsschutzschicht aus einer teiloxydierten Metallverbindung besteht, wobei es sich vorzugsweise um Verbindungen der Stoffe Silicium, Zinn und Indium handelt.

Da es bei diesen Stoffen nicht zu einer Mischung mit der vorzugsweise aus Kupfer oder Eisen bestehenden Lötschicht kommt, entfällt die seither übliche Diffusionssperrschicht, womit Materialkosten und Herstellungskosten eingespart werden.

Die Korrosionsschutzschicht wirkt, soweit sie aus teiloxydierten Materialien besteht, als Fangschicht für eindringenden Sauerstoff und gleichzeitig als Reduktionsmittel für das Lötschichtmaterial.

Besteht die Korrosionsschutzschicht aus den oxydierten Verbindungen von z.B. Silicium, Zinn oder Indium, so wirkt sie bei ausreichender Schichtdicke als undurchlässige Sperrschicht für Sauerstoff.

Da durch die Erfindung ein zumindest teilweises Wegoxydieren der Lötschicht verhindert wird, kann diese in einer minimierten Dicke aufgetragen werden, was gegenüber dem bisherigen galvanischen Auftragen der Lötschicht ein Auftragen mit der weniger aufwendigen Vakuumtechnik ermöglicht. Es sind dabei Lötschichten von einer Dicke unter einem µm möglich.

Die minimal erforderliche Dicke der Korrosionsschutzschicht wird durch das verwendete Material und den Grad der Oxydation dieses Materials bestimmt, so dass durch Variation dieser beiden Parameter auch die Dicke der Korrosionsschutzschicht variiert werden kann.

Um eine gute Haftung der Lötschicht auf dem z.B. aus Glas, Silicium, Epoxyd oder Keramik bestehenden Träger zu erreichen, kann zwischen dem Träger und der Lötschicht eine Haftvermittlerschicht aus z.B. Chrom, Titan oder Aluminium angeordnet sein.

In einer vorteilhaften Anwendung der Erfindung kann das Schichtensystem eine lötfähige An-schlussstelle der Leiterschicht einer Flüssigkri-stallanzeige sein, wobei die Leiterschicht aus einem weitgehend durchoxydierten Metall bestehen kann. Derartige Leiterschichten werden üblicherweise erst teiloxydiert auf den aus Glas bestehenden Träger aufgetragen und nachdem auch die weiteren Schichten des lötfähigen Schichtensystems aufgebracht sind, in einem Hochtempera-turprozess durchoxydiert. Dieses Durchoxydieren ist erforderlich, damit zum einen eine Widerstands-reduzierung und zum anderen die erforderliche Durchsichtigkeit der Leiterschicht erzielt wird. Da auch das lötfähige Schichtensystem diesen Hoch-temperaturprozess durchläuft, hat die Korrosions-schutzschicht eine besondere Bedeutung, da sonst die Lötschicht während des Hochtemperaturprozesses zumindest teilweise wegoxydiert.

Zur Herstellung des elektrischen Kontakts zwischen der Leiterschicht und dem lötfähigen Schichtensystem kann die Leiterschicht in den Bereich zwischen Träger und Lötschicht reichen. Sie kann dabei gleichzeitig die Haftvermittlerschicht zwischen dem Träger und der Lötschicht bilden.

Es kann aber auch zur Erzielung einer besonders guten Haftung zwischen der Lötschicht und dem Träger zwischen der Leiterschicht und der Lötschicht noch eine Haftvermittlerschicht angeordnet sein.

Da für die Leiterschicht genau wie für die Korrosionsschutzschicht Indiumzinnoxyd verwendet werden kann, kann die Korrosionsschutzschicht und die Leiterschicht aus dem selben Werkstoff bestehen. Dies ist dann besonders vorteilhaft, wenn Korrosionsschutzschicht und Leiterschicht das aus der Lötschicht und gegebenenfalls weiteren Schichten bestehende Schichtensystem sowie die davon nicht bedeckte Fläche des Trägers abdeckend in einem Arbeitsgang aufgebracht sind. In diesem Fall sind anstatt der seither üblichen fünf Arbeitsgänge zum Auftragen der Leiterschicht, der Haftvermittlerschicht, der Lötschicht, der Diffusionssperrschicht und der Korrosionsschutzschicht nur noch drei Arbeitsgänge erforderlich, um die Haftvermittlerschicht, die Lötschicht und die in einem Arbeitsgang gleichzeitig aufgebrachte Korrosionsschutzschicht und Leiterschicht auf den Träger aufzubringen.

Wird, wie es bei Flüssigkristallanzeigen erforderlich ist, auf die Korrosionsschutzschicht noch eine Orientierungsschicht aufgebracht, so kann die Dicke der Korrosionsschutzschicht noch verringert werden, da die Orientierungsschicht auch zur Verhinderung einer Diffusion von Sauerstoff zur Lötschicht mit beiträgt.

Ein Ausführungsbeispiel der Erfindung ist in der Zeichnung dargestellt. Es zeigen

Figur 1 ein erstes Ausführungsbeispiel eines erfindungsgemässen Schichtensystems Figur 2 ein zweites Ausführungsbeispiel eines erfindungsgemässen Schichtensystems.

Figur 3 ein drittes Ausführungsbeispiel eines erfindungsgemässen Schichtensystems.

Die in den Figuren dargestellten lötfähigen Schichtensysteme 3, 3' und 3'' sind auf einen Träger 1 aus Glas aufgetragen, der als eine Wand einer Flüssigkristallzelle dient.

Auf den Träger 1 ist mit einer Dicke von vorzugsweise 250–1500 Å eine Leiterschicht 2 aufgetragen, die aus Indiumzinnoxyd bestehen kann. Für diese nicht lötfähige Leiterschicht 2 bilden die Schichtensysteme 3, 3' und 3'' lötfähige Anschlussstellen, über die z.B. die Anschlüsse von als Chips ausgebildeten integrierten Schaltkreisen an die Leiterschicht 2 anschliessbar sind.

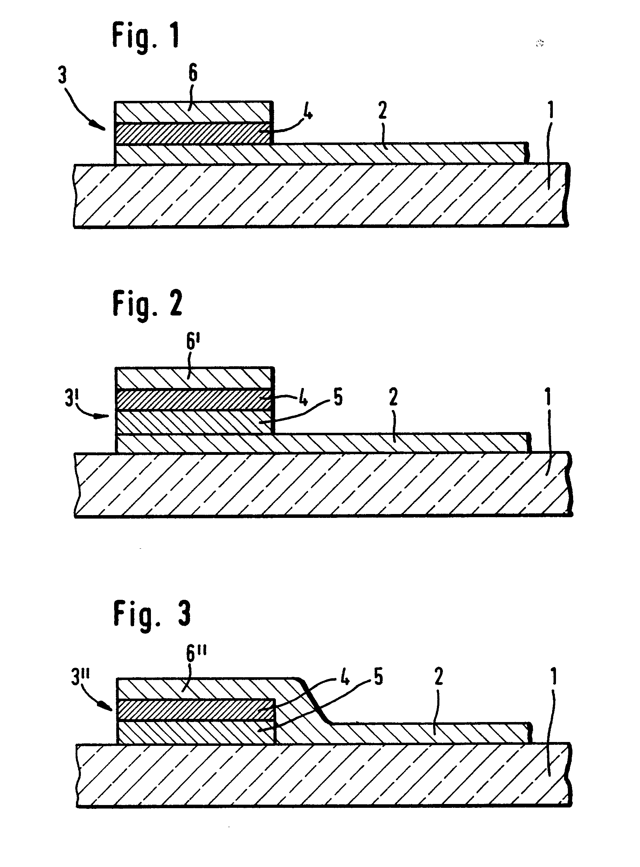

Bei dem in Figur 1 dargestellten Schichtensystem 3 ist eine aus Kupfer oder Eisen bestehende Lötschicht 4 auf die Leiterschicht 2 direkt aufgebracht, während in den Figuren 2 und 3 zwischen der Lötschicht 4 und der Leiterschicht 2 noch eine die Haftung auf dem Träger 1 verstärkenden Haftvermittlerschicht 5 aus Chrom, Titan oder Aluminium angeordnet ist.

Zum Schutz der Lötschicht 4 gegen Oxydation ist diese von einer Korrosionsschutzschicht 6, 6' bzw. 6'' abgedeckt, die aus dem gleichen, leicht korrosiven Material besteht wie die Leiterschicht 2.

Während die Korrosionsschutzschicht 6 und 6' in den Figuren 1 und 2 in einem separaten Arbeitsgang aufgetragen sind, erfolgt das Auftragen von Korrosionsschutzschicht 6'' und Leiterschicht 2 beim Ausführungsbeispiel in Figur 3 gleichzeitig in einem Arbeitsgang.

Nach dem Auftragen der einzelnen Schichten, das bei Leiterschicht 2 und die Korrosionsschutzschicht 6, 6' bzw. 6'' mit nur teiloxydiertem Material erfolgte, wird die gesamte Baueinheit einem Hochtemperaturprozess unterworfen, in dem die Korrosionsschutzschichten 6, 6' und 6'' und die Leiterschicht 2 weitgehend durchoxydiert werden. Dies ist erforderlich, um zum einen den elektrischen Widerstand der Leiterschicht herabzusetzen und zum anderen die Leiterschicht 2 transparent zu machen. Diese Transparenz der Leiterschicht ist bei der Verwendung in einer Flüssigkristallzelle erforderlich.

Da bei dem Hochtemperaturprozess aufgrund des Schutzes durch die Korrosionsschutzschicht 6, 6' bzw. 6'' kein Wegoxydieren eines Teils der Lötschicht 4 erfolgt, kann diese minimiert aufgebracht werden, was bedeutet, dass sie nur eine Dicke von etwa 1 µm zu haben braucht.

In einer nicht dargestellten Ausbildung der Erfindung kann auf den direkt die Haftvermittlerschicht tragenden Träger eine Schicht aus dem Material der Leiterschicht aufgetragen sein, die dann die Lötschicht und die Korrosionsschutzschicht trägt.

Besteht die Leiterschicht nämlich aus Indiumzinnoxyd so legiert sie zum Teil in die Lötschicht hinein. Dies führt zu einer besseren Haftung des gesamten Schichtensystems sowohl untereinander als auch auf dem Träger.

**Patentansprüche**

1. Träger-Schichten-System mit einer auf dem Träger befindlichen nicht lötfähigen Metalloxyd-Leiterschicht und einem eine Löt-Anschlussstelle für diese Leiterschicht bildenden Schichtensystem bestehend aus einer Lötschicht und einer diese überdeckenden und gegen Oxydation schützenden Korrosionsschutzschicht, dadurch gekennzeichnet, dass die Korrosionsschutzschicht (6, 6', 6'') aus einem bezüglich Oxydation korrosiven Metall oder Metalloxyd besteht, dass die Leiterschicht (2) nicht vollständig durchoxydiert ist und dass die Korrosionsschutzschicht ein solches Material und eine solche Dicke aufweist, dass sie einerseits die Lötschicht auch während eines zum Zwecke der Durchoxydierung der Leiterschicht vorgesehenen Hochtemperaturprozesses vor Oxydation schützt, andererseits aber beim Lötvorgang stören würde und deshalb vor Beginn des Lötvorgangs entfernt werden muss.

2. Träger-Schichten-System nach Anspruch 1, dadurch gekennzeichnet, dass die Korrosionsschutzschicht (6, 6', 6'') aus einer teiloxydierten Metallverbindung besteht.

3. Träger-Schichten-System nach einem der vorhergehenden Ansprüche, dadurch gekennzeichnet, dass zwischen dem Träger (1) und der Lötschicht (4) eine Haftvermittlerschicht (5) angeordnet ist.

4. Träger-Schichten-System nach einem der vorhergehenden Ansprüche, dadurch gekennzeichnet, dass das Schichtensystem (3, 3', 3'') eine lötfähige Anschlussstelle der Leiterschicht (4) einer Flüssigkristallanzeige ist.

5. Träger-Schichten-System nach einem der vorhergehenden Ansprüche, dadurch gekennzeichnet, dass die Leiterschicht (2) in den Bereich zwischen Träger (1) und Lötschicht (4) reicht.

6. Träger-Schichten-System nach Anspruch 5, dadurch gekennzeichnet, dass die Leiterschicht (2) die Haftvermittlerschicht zwischen dem Träger (1) und der Lötschicht (4) bildet.

7. Träger-Schichten-System nach einem der Ansprüche 1–5, dadurch gekennzeichnet, dass zwischen der Leiterschicht (2) und der Lötschicht (4) eine Haftvermittlerschicht (5) angeordnet ist.

8. Träger-Schichten-System nach einem der vorhergehenden Ansprüche, dadurch gekennzeichnet, dass Korrosionsschutzschicht (6, 6', 6'') und Leiterschicht (2) aus dem selben Werkstoff bestehen.

9. Träger-Schichten-System nach Anspruch 8, dadurch gekennzeichnet, dass Korrosionsschutzschicht (6'') und Leiterschicht (2) das aus der Lötschicht (4) und gegebenenfalls weiteren Schichten bestehende Schichtensystem (3''), sowie die davon nicht bedeckte Fläche des Trägers (1) abdekken.

10. Träger-Schichten-System nach einem der vorhergehenden Ansprüche zur Verwendung in einer Flüssigkristallanzeige, dadurch gekennzeichnet, dass auf die Korrosionsschutzschicht (6, 6', 6'') eine Orientierungschicht aufgebracht ist.

**Claims**

1. Support and layers system with a non-solderable metallic oxide conductor layer arranged on the support, and with a layer system forming a soldering connection point for this conductor layer and consisting of a soldering layer and of a corrosion-protective layer covering the latter and protecting against oxidation, characterised in that the corrosion-protective layer (6, 6', 6'') consists of a metallic oxide or metal which is corrosive with respect to oxidation, that the conductor layer (2) is not completely oxidised through, and that the corrosion-protective layer comprises such a material and is of such thickness that on the one hand it protects the soldering layer from oxidation even during a high-temperature process intended for the oxidising through of the conductor layer, but on the other hand it would be troublesome in the soldering operation and consequently must be removed before the start of the soldering operation.

2. Support and layers system according to claim 1, characterised in that the corrosion-protective layer (6, 6', 6'') consists of a partly oxidised metal compound.

3. Support and layers system according to one of the preceding claims, characterised in that a bond-promoting layer (5) is arranged between the support (1) and the soldering layer (4).

4. Support and layers system according to one of the preceding claims, characterised in that the layer system (3, 3', 3'') is a solderable connection point of the conductor layer (4) of a liquid-crystal display.

5. Support and layers system according to one of the preceding claims, characterised in that the conductor layer (2) extends into the region between support (1) and soldering layer (4).

6. Support and layers system according to claim 5, characterised in that the conductor layer (2) forms the bond-promoting layer between the support (1) and the soldering layer (4).

7. Support and layers system according to one of claims 1–5, characterised in that a bond-promoting layer (5) is arranged between the conductor layer (2) and the soldering layer (4).

8. Support and layers system according to one of the preceding claims, characterised in that corrosion-protective layer (6, 6', 6'') and conductor layer (2) are made of the same material.

9. Support and layers system according to claim 8, characterised in that corrosion-protective layer (6'') and conductor layer (2) cover the layer system (3'') consisting of the soldering layer (4) and possibly further layers, and also that surface of the support (1) which is not covered by said system.

10. Support and layers system according to one of the preceding claims for use in a liquid-crystal display, characterised in that an orientation layer is arranged on the corrosion-protective layer (6, 6', 6'').

**Revendications**

1. Système de couches sur substrat, comprenant une couche conductrice en oxyde métallique ne se prêtant pas au brasage et située sur le substrat, ainsi qu'un système de couches qui forme une zone de raccordement brasé pour cette couche conductrice et se compose d'une couche de brasage et d'une couche anti-corrosion recouvrant cette dernière et assurant une protection contre l'oxydation, système caractérisé par le fait que la couche anti-corrosion (6, 6', 6'') consiste en un métal ou en un oxyde métallique corrodable par oxydation; par le fait que la couche conductrice (2) n'est pas oxydée intégralement de part en part; et par le fait que la couche anti-corrosion consiste en un matériau tel et présente une épaisseur telle que, d'une part, elle protège de l'oxydation la couche de brasage également lors d'un processus à haute température prévu pour oxyder de part en part la couche conductrice, mais que, d'autre part, elle soit susceptible de perturber le processus de brasage et doive, par conséquent, être enlevée avant le début de ce processus de brasage.

2. Système selon la revendication 1, caractérisé par le fait que la couche anti-corrosion (6, 6', 6'') consiste en un composé de métal partiellement oxydé.

3. Système selon l'une des revendications précédentes, caractérisé par le fait qu'une couche d'agent d'adhérence (5) est intercalée entre le substrat (1) et la couche de brasage (4).

4. Système selon l'une des revendications précédentes, caractérisé par le fait que le système de couches (3, 3', 3'') est une zone de raccordement brasable de la couche conductrice (2) d'un dispositif d'affichage à cristaux liquides.

5. Système selon l'une des revendications précédentes, caractérisé par le fait que la couche conductrice (2) s'étend dans la région située entre le substrat (1) et la couche de brasage (4).

6. Système selon la revendication 5, caractérisé par le fait que la couche conductrice (2) forme la couche d'agent d'adhérence entre le substrat (1) et la zone de brasage (4).

7. Système selon l'une des revendications 1 à 5, caractérisé par le fait qu'une couche d'agent d'adhérence (5) est interposée entre la couche conductrice (2) et la couche de brasage (4).

8. Système selon l'une des revendications précédentes, caractérisé par le fait que la couche anti-corrosion (6, 6', 6'') et la couche conductrice (2) sont constituées par le même matériau.

9. Système selon la revendication 8, caractérisé par le fait que la couche anti-corrosion (6'') et la couche conductrice (2) recouvrent le système de couches (3'') constitué par la couche de brasage (4) et éventuellement par d'autres couches, ainsi que la surface du substrat (1) qui n'est pas recouverte par ce dernier.

10. Système selon l'une des revendications précédentes, destiné à être utilisé dans un dispositif d'affichage à cristaux liquides, système caractérisé par le fait qu'une couche d'orientation est déposée sur la couche anti-corrosion (6, 6', 6'').

### Fig. 1

### Fig. 2

### Fig. 3